# EUROPEAN PATENT SPECIFICATION

(11) **EP 2 765 429 B1**
(45) Date of publication and mention of the grant of the patent: **28.06.2017**
(21) Application number: 14153529.4
(22) Date of filing: 31.01.2014
(51) Int. Cl.: G01R 31/02, G01R 31/12, G01R 31/14

(54) **Device for testing the insulation of capacitive electric components**
Vorrichtung zum Testen der Isolierung von kapazitiven elektrischen Komponenten
Dispositif pour tester l'isolation de composants électriques capacitifs

(30) Priority: 09.02.2013 CH 4222013
(43) Date of publication of application: 13.08.2014
(73) Proprietor: Seitz Instruments AG, 5443 Niederrohrdorf (CH)
(72) Inventor: Seitz, Paul P., 5507 Mellingen (CH); Quak, Ben, 5443 Niederrohrdorf (CH); Gulski, Edward, 5443 Niederrohrdorf (CH)
(74) Representative: Spierenburg, Pieter

(56) References cited:
- DE-A1- 2 804 481
- DE-A1- 3 525 507
- DE-A1- 3 700 647
- DE-A1- 19 513 441
- US-A- 5 194 817
- US-A- 5 402 058
- Henning Oetjen ET AL: "DAC & VLF Voltage Sources", St. Pete Beach, FL, 26 May 2011 (2011-05-26), pages 1-18, XP055167834, Retrieved from the Internet: URL:http://www.pesicc.org/iccwebsite/subco mmittees/E/E04/2011/Spring2011DAC&VLF.pdf [retrieved on 2015-02-06]
- C K Dwivedi ET AL: "Light Triggering Thyristor for HVDC and other Applications", International Journal on Control System and Instrumentation, 28 February 2011 (2011-02-28), page 11, XP055167840, New York Retrieved from the Internet: URL:http://search.proquest.com/docview/128 9013067 [retrieved on 2015-02-04]

## Description

### FIELD OF THE INVENTION

The invention pertains to a device for testing the insulation of capacitive electric components, such as LV (low voltage), MV (medium voltage) and HV (high voltage) cables and cable accessories, motors and generators, switchgears and other insulated components, having a metallic core and an outer insulation of solid, liquid and/or gaseous material.

### BACKGROUND OF THE INVENTION

Testing of above mentioned components is being performed during all phases of the component lifetime, for quality control of the component itself, quality control of installation workmanship and for condition assessment. In general tests are performed at both the specified nominal voltage as well as reduced or elevated voltage levels. This test can be performed as a simple voltage withstand test, or in combination with different diagnostic parameters.

Testing methods with Damped Alternating Current (DAC) can be used for testing above mentioned electric components, and all other HV components or circuits assembled from those components, which act as a capacitive load. Even components which have no or a very small capacitive load can be tested by connecting a basic load capacitance in parallel to the test object, i.e. the capacitive electric component.

With DAC test systems, the capacitance of the object under test is charged with a unipolar continuously increasing voltage through an inductor up to a defined test voltage level (the energizing phase). When this test voltage level is reached, an HV switch short circuits the other side of the inductor to ground (the switching phase). Now a resonant circuit between the inductor and the capacitance of the test object is formed. This results to a damped AC voltage signal (the so-called "LC resonant phase").

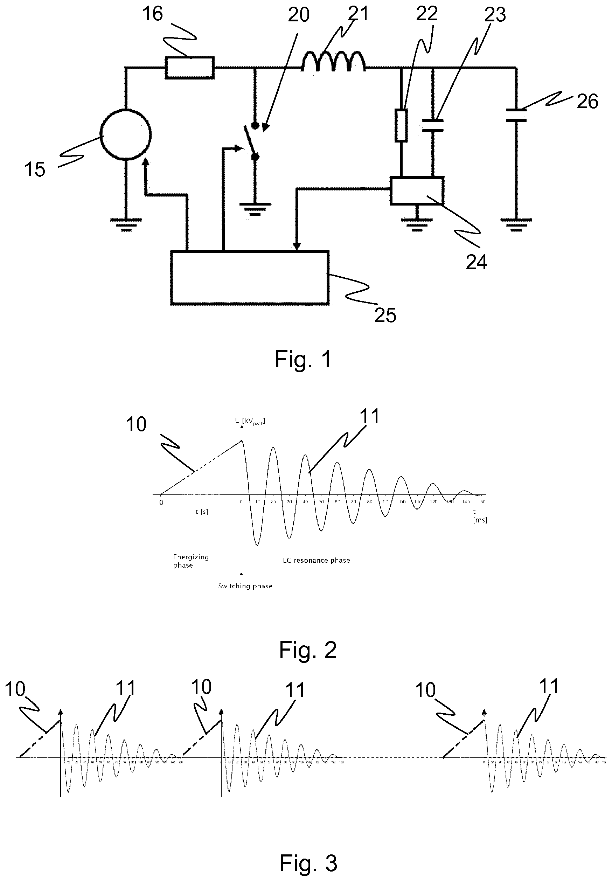

In Figure 1 a conventional testing device is depicted which shows an HV source or power supply 15. The output of the HV source 15 is a continuously increasing voltage. In series a resistance 16, a HV solid-state switch 20 and an inductor 21 with inductivity L are connected to power supply 15. The inductor 21 is connected over a resistive voltage divider 22 and a PD coupling capacitance 23 with a coupling device 24 which is connected to a process control unit 25 which has a data storage module, optionally a PD analysis module and an evaluation module, in which an estimate of dielectric losses is stored. The inductor 21 is further connected in series with a test object or capacitive electric component 26 having a capacitance C. The process control unit 25 is controlling the switching of the solid state switch 20 and controls the voltage of the power supply 15 (indicated by arrows). As generally known HV solid-state switches can be triggered by a voltage at the gate, so that the switch is closed. However, the solid-state switch 20 is only disconnected as the voltage over the switch is extinguished. Figure 2 shows the energizing phase (continuously increasing voltage) 10 and the LC resonance phase 11 which is displayed on the monitor of the PD detector. This process can be a single operation or repeated several times when preferred as depicted in Figure 3.

Traditionally, besides early attempts with full mechanical switches that cause arcing and therefore high electromagnetic noise emissions, solid state switches comprised of one or more semiconductors such as IGBTs (insulated gate bipolar transistors) or LTTs (light triggered thyristors) in combination with anti-parallel diodes are being used to avoid noise at the switching moment. All these switches are closed in the switching phase and stay closed during the whole LC resonant phase, i.e. when the LC circuit of the inductor 21 and the test object 26 is charged by electrical energy.

In international and national norms different test-voltages and voltage shapes, such as continuous AC at mains frequency (50/60Hz), resonance AC with variable frequency, DC, DAC (damped alternating current) and VLF (very low frequency, i.e. about 0.1 Hz) test voltages are described.

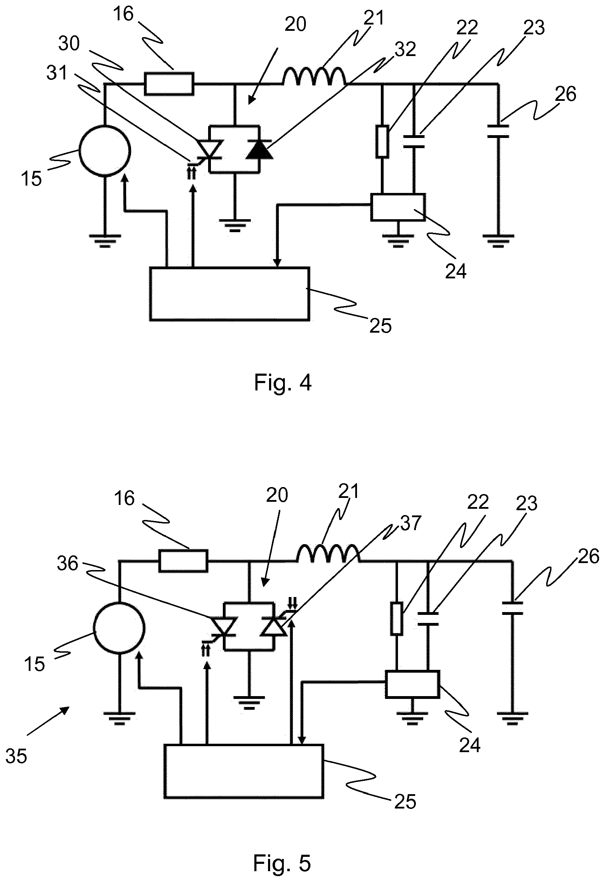

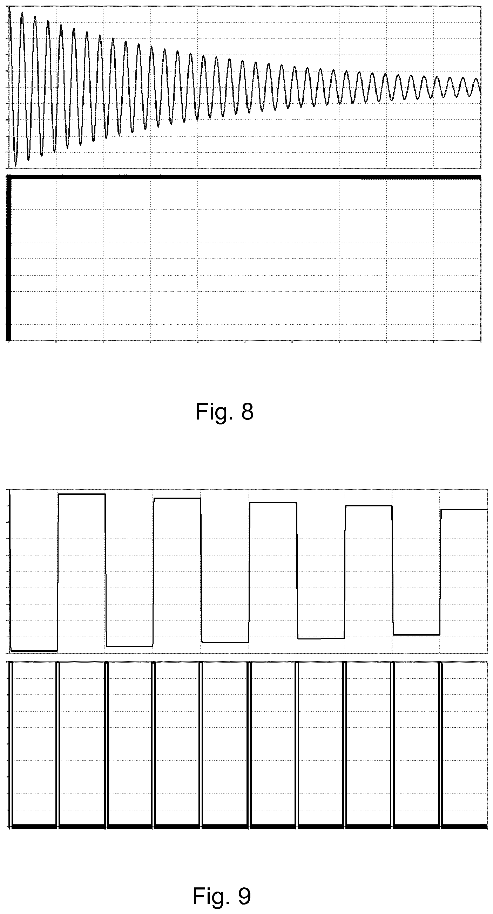

In Figure 4 a traditional DAC system switch 20 consisting of a thyristor 30 with gate 31 and an anti-parallel diode 32 is shown, which is implemented in the circuitry of Fig. 1. The control pattern of this traditional DAC system is depicted in Figure 9. The upper graph shows the damped AC, the lower graph the square-wave control signals of the process control unit 25.
The DAC systems actually available on the market are designed to generate only DAC voltages in the test objects or capacitive electric components.
Document "DAC & VLF Voltage Sources" of Henning Oetjen et.al., St. Pete Beach, FL, 26 May 2011 shows in the figure on page 16 exactly the state of the art as depicted in Figure 1 of the present patent application and described on page 2, lines 4 to 21. The figures on the right side (LRC circuit and signal diagram) show clearly that the switch is closed (and stays closed) during the resonant phase of the LC circuit.
In this document only the very well-known Damped AC Technology is described, which has been developed and marketed by applicant under the expression OWTS, which is now a standard expression for Oscillating Wave Test System. DE-A-102 06 788 describes a testing device for voltage controlling of cables and cable sets. Figure 1 shows a basic circuitry of a device for voltage testing of cables according to the state of the art. The cable to be tested is electrically connected to a DC source, wherein the switching is performed by means of a supporting condenser and a change-over inductor. When the test cable is charged by the DC source, the switch is closed and an electromagnetic change-over process is induced so that the polarity at the test cable is changed. If the other switch is closed, the polarity is changed again to the original polarity. Although not described here, the switch is opened simultaneously as the other switch is closed. A more proper description of the function of the circuitry of the state of the art is described in EP 0 231 459 B, Figures 1 and 3, which is mentioned in the introduction of and is related to the circuitry of Figure 1 of DE-A-102 06 788.

It is an object of the present invention to present a novel system which can generate alternatively to DAC voltages also DC voltages, VLF (very low frequency) voltages, AC voltages and square-wave voltages.

### SOLUTION OF THE INVENTION

This object is achieved by a testing device with the features of claim 1.

The device for testing of the insulation of capacitive electric components according to the present invention has a metallic core and an outer insulation comprising a power supply, a solid-state switch for short-circuiting the power supply and an inductor, wherein the inductor and the capacitance of the capacitive electric component provide an LC circuit. The solid-state switch of the present invention is additionally designed for opening when the LC circuit is charged by electrical energy. The solid state-state switch comprises a thyristor element connected with an antiparallel thyristor element or comprises an insulated gate bipolar transistor connected with an antiparallel insulated gate bipolar transistor.

Preferably a voltage divider and/or coupling capacitance are provided in the device for being electrically connected in parallel to the capacitive electric component, said divider is provided for a voltage measurement device and said coupling capacitance is provided for coupling a PD analysis module.

Further a process control circuit may be provided for controlling the timing between opening and closing of the solid-state switch.

In another preferred embodiment of the device an overvoltage protection is connected in parallel to the solid-state switch.

In a further preferred embodiment the thyristor element and the antiparallel thyristor element are light triggered thyristor elements.

The process control unit can be designed to control the solid-state switch to generate VLF voltages.

The process control unit can also be designed to control the solid-state switch to generate DC voltages.

The process control unit may further be designed to control the solid-state switch to generate AC voltages.

In another embodiment of the device the process control unit may be designed to control the solid-state switch to generate DAC voltages.

In a further preferred embodiment of the device the power supply may be unipolar and provided for compensating losses in unipolar direction.

The power supply may also comprise a switch in order to compensate losses in bipolar direction.

Further it is advantageous if at least two unipolar power supplies are provided for compensating losses in bipolar direction.

In another advantageous embodiment the power supply can be bipolar and provided for compensating losses in bipolar direction.

The inductor may have a variable inductance provided for minimizing system losses and/or optimising the frequency of the LC circuit.

On the other hand the inductor may be a selectable inductor provided for minimizing system losses and/or optimizing the frequency of the LC circuit.

In another preferred embodiment a capacitor may be connected electrically in parallel to the capacitive electric component to be tested in order to minimize system losses and/or to optimise the frequency of the LC circuit.

### BRIEF DESCRIPTION OF THE FIGURES

In the following, the invention is described in greater detail, by way of example, with reference to the accompanying drawings, in which:
- Fig. 5: shows a test circuitry with a switch according to the present invention,
- Fig. 6: shows a test circuitry similar to Fig. 5 in which an overvoltage protection is provided,
- Fig. 7: shows a test circuitry similar to Fig. 5 in which two pairs of antiparallel solid-state switches are provided, and
- Figs. 8 to 14: show the control signals of the process control unit (lower graph) and the voltage of the LC circuit (upper graph).

### DETAILED DESCRIPTION

In Figure 5 the novel circuitry 35 for testing a capacitive electric component 26 is shown. The capacitive electric component is defined as an electrical cable as such, but also as cable accessories, cable components, motors and generators, switchgears and other insulated components, having a metallic core and an outer insulation of solid, liquid or gaseous material. The circuitry 35 has the same components as the testing device of Figure 4, wherein the solid-state switch 20 is provided by two antiparallel connected light triggered thyristors 36 and 37, which are controlled (indicated by arrows) by the process control unit 25.

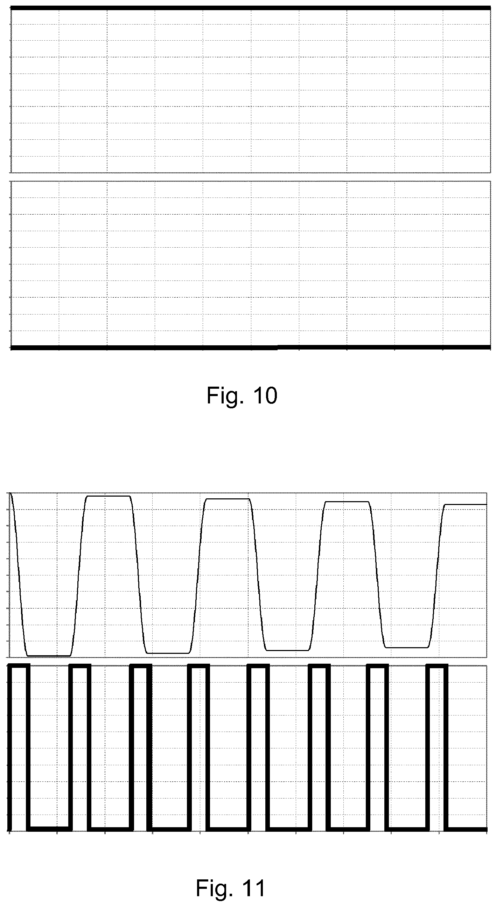

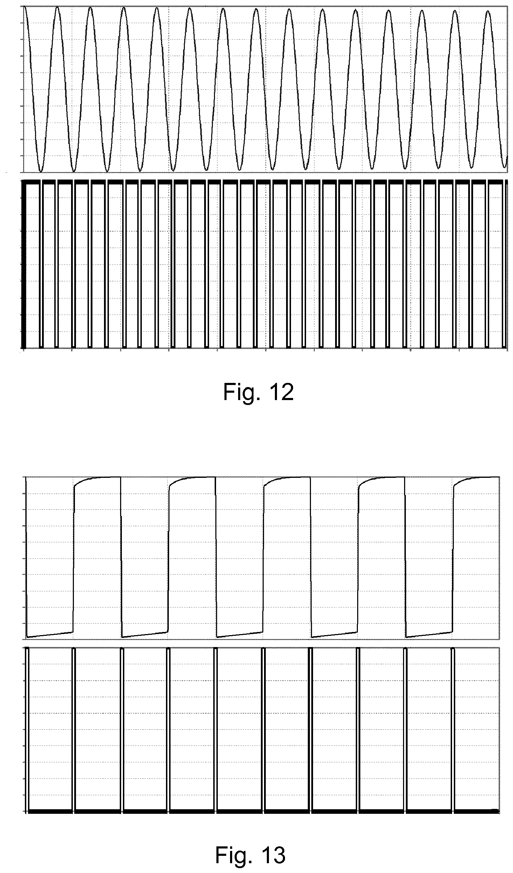

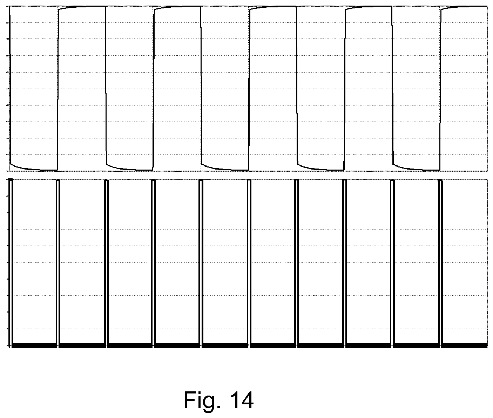

The system of the present invention is designed such that the HV switch with the two antiparallel connected thyristors 36 and 37 and the process controller 25 are capable of switching ON and additionally switching OFF during the LC resonant phase, i.e. under electrical charge of the LC circuit. The inductance L of the test circuitry 35, in combination with the capacitance C of the test object will create a smooth cosine curved zero crossing, and the frequency of the resulting voltage signal can be controlled by timing of the re-closing and re-opening of the thyristors 36 and 37. The system of the present invention can be used to generate a DAC mode as depicted in Figure 8, an uncompensated VLF mode as depicted in Figure 9, a DC mode as depicted in Figure 10, an uncompensated AC mode as depicted in Figure 11, a sinusoidal AC mode as depicted in Figure 12, a unipolar compensated VLF mode as depicted in Figure 13 and a bipolar compensated VLF mode as depicted in Figure 14. Above mentioned modes can be selected by the control signals of the process control unit 25, which are given to the gates of the thyristors 36 and 37. Instead of light triggered thyristors 36 and 37 also normal gate triggered thyristors can be used. Instead of thyristors also insulated gate bipolar transistors (IGBT) can be used.

The losses of the inductor 21 are given by the coupling factor and the resistance. The inductor 21 used may be of variable inductance. In the case of AC and VLF modes a reduction of required power can be achieved by use of a smaller inductance to minimize losses. In the case of DAC mode the DAC frequency is controlled by use of a larger inductance. Thus, a switchable inductance can be used to optimize losses and the operation frequency between DAC and AC or VLF mode.

Furthermore the power supply 15 of the system can also be used to compensate for losses in the circuit to keep the test voltage level constant. In addition a second power supply can be used to compensate for losses in both polarities.

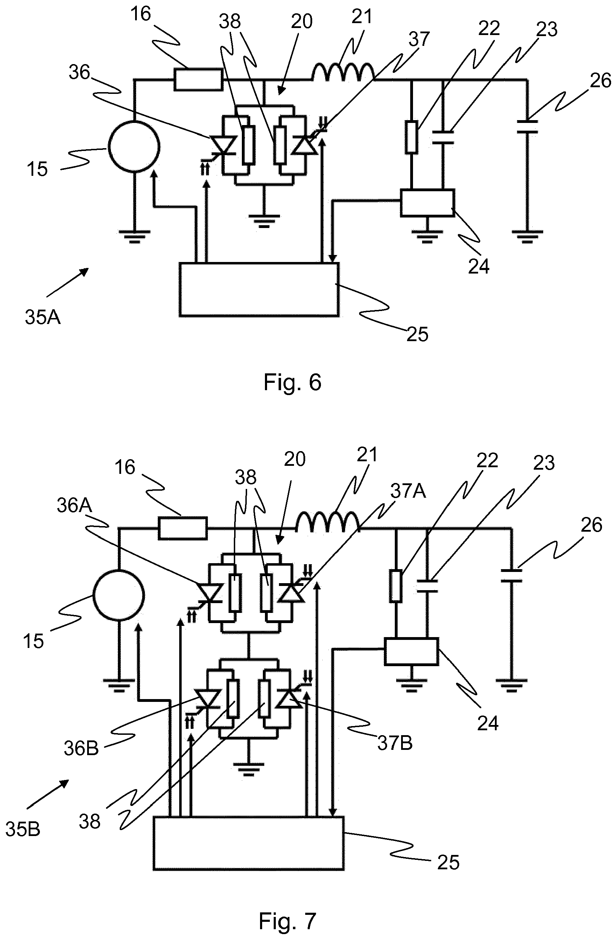

In Figure 6 a test circuitry 35A similar to the circuitry 35 of Figure 5 is shown, wherein the thyristors 36 and 37 are protected against an overvoltage by a parallel overvoltage protection device 38, which can be a VDR, a Zener diode or the like.

In Figure 7 another test circuitry 35B is provided with two pairs of antiparallel thyristors 36A, 37A and 36B, 37B which are connected in series and provided also with overvoltage protection devices 38. This modified test circuitry 35B has the advantage that larger electrical voltages can be switched on and off, in order to test very long cable components.

The power supply 15 can be unipolar for compensating losses in unipolar direction, but can also comprise a switch in order to compensate losses in bipolar direction. On the other hand at least two unipolar power supplies 15 can be provided or the power supply 15 can be bipolar for compensating losses in bipolar direction.

The inductor 21 may have a variable inductance in order to minimize system losses and/or to optimise the frequency of the LC circuit. On the other hand the inductor 21 can be a selectable inductor which is provided for minimizing system losses and/or optimising the frequency of the LC circuit. Further it is also possible to connect a capacitor electrically in parallel to the capacitive electric component 26 to be tested in order to minimize system losses and/or to optimise the frequency of the LC circuit.

## Claims

1. Device for testing of the insulation of capacitive electric components (26) having a metallic core and an outer insulation comprising a power supply (15) and an inductor (21) in series with the power supply (15), whereas the capacitance of the capacitive electric component (26) is to be electrically connected in series with the inductor (15) for providing an LC circuit, wherein the power supply (15) being provided for charging the LC circuit, and a solid state switch (20) provided for short-circuiting the power supply (15) and the inductor (21) to ground, such that the LC circuit is resonant after closing the switch (20), **characterized in that**, the solid-state switch (20) being formed of semiconductors selected from a group comprising a thyristor element (36) connected with an antiparallel thyristor element (37) and an insulated gate bipolar transistor connected with an antiparallel insulated gate bipolar transitor, such that the solid-state switch is additionally designed for opening when the LC circuit is in the resonant phase and charged by electrical energy.

2. Device according to claim 1, **characterized in that** a voltage divider (22) and/or coupling capacitance (23) is provided for being electrically connected in parallel to the capacitive electric component (26), said divider (22) is provided for a voltage measurement device and said coupling capacitance (23) is provided for coupling a PD analysis module.

3. Device according to claim 1 or 2, **characterized in that** a process control circuit (25) is provided for controlling the timing between opening and closing of the solid-state switch (20).

4. Device according to one of claims 1 to 3, **characterized in that** an overvoltage protection (38) is connected in parallel to the solid-state switch (20).

5. Device according to claim 1 to 4, **characterized in that** the thyristor element (36) and the antiparallel thyristor element (37) are light triggered thyristor elements.

6. Device according to one of claims 1 to 5, **characterized in that** the power supply (15) is unipolar and provided for compensating losses in unipolar direction.

7. Device according to one of claims 1 to 5, **characterized in that** the power supply (15) comprises a switch in order to compensate losses in bipolar direction.

8. Device according to claim 6, **characterized in that** at least two unipolar power supplies (15) are provided for compensating losses in bipolar direction.

9. Device according to one of claims 1 to 5, **characterized in that** the power supply (15) is bipolar and provided for compensating losses in bipolar direction.

10. Device according to one of claims 1 to 9, **characterized in that** the inductor (21) having a variable inductance provided for minimizing system losses and/or optimising the frequency of the LC circuit.

11. Device according to one of claims 1 to 9, **characterized in that** the inductor (21) is a selectable inductor provided for minimizing system losses and/or optimizing the frequency of the LC circuit.

12. Device according to one of claims 1 to 11, **characterized in that** a capacitor is connected electrically in parallel to the capacitive electric component (26) to be tested in order to minimize system losses and/or to optimise the frequency of the LC circuit.

## Patentansprüche

1. Vorrichtung zum Testen der Isolierung von kapazitiven elektrischen Komponenten (26) mit einem metallischen Kern und einer äußeren Isolierung, umfassend eine Stromversorgung (15) und eine Induktionsspule (21) in Reihe mit der Stromversorgung (15), während die Kapazität der kapazitiven elektrischen Komponente (26) elektrisch in Reihe mit der Induktionsspule (15) zu schalten ist, um einen LC-Kreis bereitzustellen, wobei die Stromversorgung (15) vorgesehen ist, um den LC-Kreis aufzuladen, und ein Festkörperschalter (20) vorgesehen ist, um die Stromversorgung (15) und die Induktionsspule (21) mit der Erde kurzzuschließen, so dass der LC-Kreis nach dem Schließen des Schalters (20) resonant ist, **dadurch gekennzeichnet, dass** der Festkörperschalter (20) aus Halbleitern gebildet ist, die aus einer Gruppe ausgewählt sind, die Folgendes umfasst: ein Thyristorelement (36), das mit einem antiparallelen Thyristorelement (37) verbunden ist, und einen Bipolartransistor mit isolierter Gate-Elektrode, der mit einem antiparallelen Bipolartransistor mit isolierter Gate-Elektrode verbunden ist, so dass der Festkörperschalter zusätzlich dafür ausgelegt ist, sich zu öffnen, wenn sich der LC-Kreis in der Resonanzphase befindet und mit elektrischer Energie aufgeladen wird.

2. Vorrichtung nach Anspruch 1, **dadurch gekennzeichnet, dass** ein Spannungsteiler (22) und/oder eine Koppelkapazität (23) vorgesehen ist, um mit der kapazitiven elektrischen Komponente (26) elektrisch parallel geschaltet zu werden, wobei der Teiler (22) für eine Spannungsmessvorrichtung vorgesehen ist und die Koppelkapazität (23) zum Ankoppeln eines TE-Analysemoduls vorgesehen ist.

3. Vorrichtung nach Anspruch 1 oder 2, **dadurch gekennzeichnet, dass** ein Prozesssteuerungskreis (25) vorgesehen ist, um die Zeit zwischen dem Öffnen und dem Schließen des Festkörperschalters (20) zu steuern.

4. Vorrichtung nach einem der Ansprüche 1 bis 3, **dadurch gekennzeichnet, dass** ein Überspannungsschutz (38) parallel mit dem Festkörperschalter (20) geschaltet ist.

5. Vorrichtung nach Anspruch 1 bis 4, **dadurch gekennzeichnet, dass** das Thyristorelement (36) und das antiparallele Thyristorelement (37) lichtgezündete Thyristorelemente sind.

6. Vorrichtung nach einem der Ansprüche 1 bis 5, **dadurch gekennzeichnet, dass** die Stromversorgung (15) unipolar ist und dafür vorgesehen ist, Verluste in unipolarer Richtung zu kompensieren.

7. Vorrichtung nach einem der Ansprüche 1 bis 5, **dadurch gekennzeichnet, dass** die Stromversorgung (15) einen Schalter umfasst, um Verluste in bipolarer Richtung zu kompensieren.

8. Vorrichtung nach Anspruch 6, **dadurch gekennzeichnet, dass** wenigstens zwei unipolare Stromversorgungen (15) vorgesehen sind, um Verluste in bipolarer Richtung zu kompensieren.

9. Vorrichtung nach einem der Ansprüche 1 bis 5, **dadurch gekennzeichnet, dass** die Stromversorgung (15) bipolar ist und dafür vorgesehen ist, Verluste in bipolarer Richtung zu kompensieren.

10. Vorrichtung nach einem der Ansprüche 1 bis 9, **dadurch gekennzeichnet, dass** die Induktionsspule (21) eine variable Induktivität aufweist, um Systemverluste zu minimieren und/oder die Frequenz des LC-Kreises zu optimieren.

11. Vorrichtung nach einem der Ansprüche 1 bis 9, **dadurch gekennzeichnet, dass** die Induktionsspule (21) eine auswählbare Induktionsspule ist, die dafür vorgesehen ist, Systemverluste zu minimieren und/oder die Frequenz des LC-Kreises zu optimieren.

12. Vorrichtung nach einem der Ansprüche 1 bis 11, **dadurch gekennzeichnet, dass** ein Kondensator elektrisch parallel mit der zu testenden kapazitiven elektrischen Komponente (26) geschaltet ist, um Systemverluste zu minimieren und/oder die Frequenz des LC-Kreises zu optimieren.

## Revendications

1. Dispositif pour tester l'isolation de composants électriques capacitifs (26) possédant un noyau métallique et une isolation extérieure comprenant une alimentation électrique (15) et un inducteur (21) monté en série avec l'alimentation électrique (15), tandis que la capacité du composant électrique capacitif (26) doit être montée électriquement en série avec l'inducteur (15) pour fournir un circuit à constantes localisées, dans lequel l'alimentation électrique (15) est fournie pour charger le circuit à constantes localisées, et un commutateur à semi-conducteurs (20) est fourni pour court-circuiter l'alimentation électrique (15) et l'inducteur (21) à la terre, de sorte que le circuit à constantes localisées est résonant après la fermeture du commutateur (20), **caractérisé en ce que** le commutateur à semi-conducteurs (20) est formé de semi-conducteurs sélectionnés à partir d'un groupe comprenant un élément de thyristor (36) connecté à un élément de thyristor antiparallèle (37) et un transistor bipolaire de déclenchement isolé connecté à un transistor bipolaire de déclenchement isolé antiparallèle, de sorte que le commutateur à semi-conducteurs est conçu en outre pour s'ouvrir lorsque le circuit à constantes localisées est en phase résonante et chargé par de l'énergie électrique.

2. Dispositif selon la revendication 1, **caractérisé en ce qu'**un réducteur de tension (22) et/ou une capacité de couplage (23) sont prévus pour être montés électriquement en parallèle avec le composant électrique capacitif (26), ledit réducteur (22) est fourni pour un dispositif de mesure de tension et ladite capacité de couplage (23) est fournie pour coupler un module d'analyse des décharges partielles.

3. Dispositif selon la revendication 1 ou 2, **caractérisé en ce qu'**un circuit de contrôle de processus (25) est fourni pour contrôler le temps entre l'ouverture et la fermeture du commutateur à semi-conducteurs (20).

4. Dispositif selon la revendication 1 à 3, **caractérisé en ce qu'**un parasurtenseur (38) est monté en parallèle avec le commutateur à semi-conducteurs (20).

5. Dispositif selon la revendication 1 à 4, **caractérisé en ce que** l'élément de thyristor (36) et l'élément de thyristor antiparallèle (37) sont des éléments de thyristor déclenchés par la lumière.

6. Dispositif selon l'une des revendications 1 à 5, **caractérisé en ce que** l'alimentation électrique (15) est unipolaire et fournie pour compenser les pertes dans la direction unipolaire.

7. Dispositif selon l'une des revendications 1 à 5, **caractérisé en ce que** l'alimentation électrique (15) comprend un commutateur afin de compenser les pertes dans la direction bipolaire.

8. Dispositif selon la revendication 6, **caractérisé en ce qu'**au moins deux alimentations électriques unipolaires (15) sont fournies pour compenser les pertes dans la direction bipolaire.

9. Dispositif selon l'une des revendications 1 à 5, **caractérisé en ce que** l'alimentation électrique (15) est bipolaire et fournie pour compenser les pertes dans la direction bipolaire.

10. Dispositif selon l'une des revendications 1 à 9, **caractérisé en ce que** l'inducteur (21) ayant une inductance variable est fourni pour minimiser les pertes du système et/ou optimiser la fréquence du circuit à constantes localisées.

11. Dispositif selon l'une des revendications 1 à 9, **caractérisé en ce que** l'inducteur (21) est un inducteur sélectionnable fourni pour minimiser les pertes du système et/ou optimiser la fréquence du circuit à constantes localisées.

12. Dispositif selon l'une des revendications 1 à 11, **caractérisé en ce qu'**un condensateur est monté électriquement en parallèle avec le composant électrique capacitif (26) à tester afin de minimiser les pertes du système et/ou d'optimiser la fréquence du circuit à constantes localisées.
